# FASCICULE DE BREVET EUROPEEN

(11) **EP 0 511 056 B1**
(45) Date de publication et mention de la délivrance du brevet: **16.10.1996**
(21) Numéro de dépôt: 92401079.6
(22) Date de dépôt: 17.04.1992
(51) Int. Cl.: H01L 39/22

(54) **Structure de jonction Josephson**
Josephsonjunctionstruktur
Josephson junction structure

(30) Priorité: 23.04.1991 FR 9104996
(43) Date de publication de la demande: 28.10.1992
(73) Titulaire: THOMSON-CSF, 75008 Paris (FR)
(72) Inventeur: Cabanel, Régis, F-92045 Paris la Défense (FR); Garry, Guy, F-92045 Paris la Défense (FR); Schuhl, Alain, F-92045 Paris la Défense (FR); Ghyselen, Bruno, F-92045 Paris la Défense (FR)
(74) Mandataire: Simonnet, Christine

(56) Documents cités:
- EP-A- 0 366 949
- EP-A- 0 427 640
- PATENT ABSTRACTS OF JAPAN vol. 13, no. 232 (E-765) 29 Mai 1989 & JP-A-1 039 084
- APPLIED PHYSICS LETTERS. vol. 56, no. 15, 9 Avril 1990, NEW YORK US, pages 1487-1489; H. AKOH ET AL.: "Anisotropic Josephson junction of Y-Ba-Cu-O/Au/Nb film sandwiches"

## Description

La présente invention concerne la structure d'une jonction Josephson, comportant une barrière non supraconductrice en sandwich entre deux couches supraconductrices. La structure de l'invention rend plus aisée la réalisation d'une jonction Josephson, en permettant de profiter de plus fortes longueurs de cohérence avec les matériaux dits supraconducteurs à haute température critique (SHTC)

L'effet Josephson est un effet lié aux supraconducteurs, selon lequel un courant supraconducteur, ou supracourant, peut traverser une barrière entre deux supraconducteur. Si la barrière est isolante ou semiconductrice , son épaisseur doit être d'ordre de la longueur de cohérence. Si la barrière est un métal normal, son épaisseur maximale dépend de la longueur de cohérence dans le supraconducteur et du libre parcours moyen électronique dans le métal.

Les jonctions Josephson sont bien connues, et, à titre d'exemple, le document EP-A-0 427640 en montre un modèle simple, avec une barrière en or et des matériaux supraconducteurs dont le grand axe "C" de la maille cristalline est parallèle au plan de la barrière, tandis que le document EP-A-0 366 949 en montre un modèle comportant une double barrière en or et Bi₄ Ti₃ O₁₂. Les contacts électriques y sont pris directement, sans couches d'accès.

Une jonction Josephson est constituée par une barrière de matériau isolant entre deux couches de supraconducteurs : si la couche de matériau normal est assez fine, et d'épaisseur au plus égale à la somme des longueurs de cohérence des deux couches de matériaux supraconducteurs, alors un supracourant traverse cette couche de matériau isolant.

En fait, il est très délicat de réaliser une jonction Josephson car, selon la nature du matériau non supraconducteur (métal, semiconducteur, isolant), la couche barrière a une du film, au moins un contact électrique étant pris sur la dite couche d'accès, cette jonction étant caractérisée en ce que le grand axe "c" de la maille cristalline du film est perpendiculaire au grand axe "c" de la maille cristalline de la couche d'accès, les dits axes "c" étant perpendiculaires aux plans CuO de matériau supraconducteur.

L'invention sera mieux comprise par la description plus détaillée qui suit d'un exemple de réalisation, en conjonction avec les figures jointes en annexe, qui épaisseur comprise entre 0,3 et 0,5 nm. Il est très difficile d'obtenir une telle barrière d'épaisseur régulière, homogène et sans court-circuits.

Dans le cas où les supraconducteurs sont des oxydes de cuivre, de baryum et de terre rare, de la famille connue sous le nom YBaCuO, l'invention apporte un perfectionnement à la réalisation d'une jonction Josephson, en proposant d'exploiter la plus grande longueur de cohérence des supraconducteurs à haute température critique parallèlement aux plans CuO saturés, dans le cristal d'YBaCuO. Par conséquent, si au moins l'une des deux couches de supraconducteurs, qui sont en contact avec une barrière pour former une jonction Josephson, a ses plans CuO saturés perpendiculaires à la barrière, la longueur de cohérence dans la barrière est plus grande, ce qui signifie que la barrière peut être réalisée avec une plus forte épaisseur (1,5 à 2 nm), donc plus facilement. L'invention est applicable à tout autre famille de supraconducteurs anisotropes.

L'invention réside donc dans une structure de jonction Josephson, formée par une couche de barrière non supraconductrice située entre deux couches supraconductrices, telle que pour l'une au moins de ces deux dites couches les plans cristallographiques de CuO sont perpendiculaires à la couche de barrière. On peut également considérer que le grand axe, dans la maille cristalline d'YBaCUO, est perpendiculaire aux plans CuO, et que dans une jonction Josephson selon l'invention, les couches supraconductrices en contact avec la barrière sont déposées de façon que le grand axe de leur maille soit parallèle à la barrière.

De façon plus précise, l'invention consiste en une structure de jonction Josephson, formée entre une barrière non supraconductrice et au moins un film en matériau supraconducteur à haute température de la famille (TR) Ba CuO, dans laquelle TR est une terre rare, le dit film étant en contact par sa surface avec au moins une couche d'accès électrique en matériau supraconducteur de même type que celui représentent :
- figure 1 : schéma cristallographique d'une molécule de supraconducteur de type YBaCuO
- figure 2 : coupe d'une jonction Josephson selon l'invention,

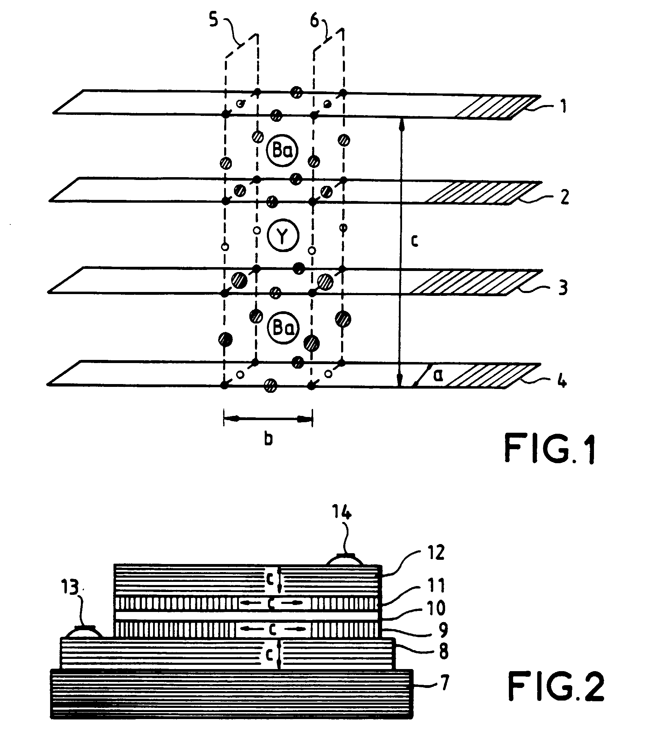

La figure 1 donne la répartition spatiale des atomes dans un cristal de l'un de ces matériaux supraconducteurs, à haute température critique, que l'on désigne par commodité les YBaCu0, bien que l'atome d'yttrium Y puisse plus généralement être remplacé par un atome de terre rare, tel que le dysprosium. Ces corps cristallisent dans le système orthorhombique. Sur le cristal élémentaire de la figure 1, on identifie facilement l'atome de terre rare Y et les deux atomes de baryum Ba. Les atomes de cuivre sont représentés par des petits cercles noirs, les atomes d'oxygène par des moyens cercles hachurés et les lacunes par des petits cercles blancs. Le nombre des lacunes dans le cristal dépend du degré d'oxydation, et tous les plans CuO ne sont pas également oxydés. Ainsi, si l'on considère les quatre plans CuO repérés 1 à 4, les deux plans centraux 2 et 3 sont saturés en oxygène (4 atomes Cu et 4 atomes 0 chacun) tandis que les deux plans externes 1 et 4 ne sont pas saturés en oxygène (4 atomes Cu, 2 atomes 0 et 2 lacunes chacun). C'est un fait connu que la conductibilité est plus grande dans les plans saturés 2 et 3 plutôt que dans les plans non saturés 1 et 4 ou dans les plans orthogonaux repérés 5 et 6. Il est aussi connu que la longueur de cohérence, pour un couple donné supraconducteur/non -supraconducteur, est plus forte parallèlement à ces plans CuO saturés. Corrélativement, la longueur de cohérence, pour le même couple, est moins forte parallèlement aux plans repérés 5 et 6.

Ce qui signifie qu'une barrière non-supraconducteur dont l'épaisseur se mesure parallèlement aux plans CuO saturés 2 et 3 peut être plus épaisse - donc plus facile à réaliser - q'une barrière dont l'épaisseur serait parallèle aux plans 5 et 6.

De façon plus générale, un cristal orthorhombique d'YBaCuO a :
- un petit axe "a" (a = 3,82 A°)
- un petit axe "b" (b = 3,89 A°)
- un grand axe "c" (c = 11, 69 A°) qui est parallèle à l'alignement Ba-Y-Ba, et perpendiculaire aux plans CuO saturés 2 et 3.

La longueur de cohérence dans la barrière est plus grande si celle-ci est parallèle à l'axe "c" de la maille d'YBaCuO.

La figure 2 représente une première structure de jonction Josephson selon l'invention. Elle comporte :
- un substrat 7,
- une couche 8 de matériau supraconducteur, première couche d'accès du courant à la jonction Josephson,
- la jonction Josephson formée par une barrière 10 en contact avec au moins l'une parmi les deux couches supraconductrices 9 et 11,
- une couche 12 de matériau supraconducteur, seconde couche d'accès du courant à la jonction Josephson.

Pour l'ensemble de ces couches les traits qui hachurent les couches représentent les plans parallèles aux plans CuO saturés; soit encore les plans perpendiculaires aux grands axes "c" des mailles cristallines.

Le substrat 7 peut être en titanate de strontium SrTiO₃, par exemple, mais, dans cette première structure dite "structure CA", la coupe est parallèle aux plans cristallographiques (001), symbolisés par des traits horizontaux sur le substrat 7.

Les couches d'accès 8 et 12, en supraconducteur de la famille (TR) Ba₂ Cu₃ O₇ (TR = terre rare) qui s'accorde bien en paramètre de maille avec Sr Ti O₃, ont leurs plans CuO saturés parallèles à la barrière 10, c'est à dire leur axe "c" perpendiculaire à la barrière.

Les deux films supraconducteurs 9 et 11, du même type de matériau (TR) Ba₂ Cu₃ O₇, ont au contraire leurs plans CuO saturés perpendiculaires à la barrière 10, de sorte que la longueur de cohérence dans la barrière, est plus forte que pour une orientation différente. L'axe "c" de leur maille cristallographique est ainsi parallèle à la barrière.

La barrière 10 est constituée par un film, d'épaisseur de l'ordre de la longueur de cohérence, soit au plus de l'ordre de 1,5 à 2 mm, d'un matériau qui n'est pas un supraconducteur. Dans les barrières de type SNS (supraconducteur-normal-supraconducteur) c'est un métal "normal" tel que l'or ou l'argent. Dans les barrières de type SIS (supraconducteur-isolant-supraconducteur), c'est un isolant ou oxyde de terre rare, tel que BaF₂, MgO, ZrO₃, SiTiO₃, oxyde de terre rare, AlGaO₃, La Ga O₃... etc. Dans tous les cas, la barrière et le ou les films qui forment la jonction Josephson doivent être accordés en paramètres de maille.

Les accès en courant à la jonction Josephson sont pris par deux contacts 13 et 14, sur les couches d'accès 8 et 12. L'interconnexion est préférablement en matériaux supraconducteurs.

Pour les matériaux supraconducteurs à haute température critique de la famille des (TR) Ba₂ Cu₃ O₇, l'épitaxie de films d'orientation cristalline "a" sur "c", ou inversement, est réalisable en raison du bon accord entre le paramètre "c" et 3 fois le paramètre "a" (3a) d'une maille cristalline.

Les structures de jonctions Josephson selon l'invention peuvent être réalisées par plusieurs méthodes de dépôt, dont la technique d'ablation laser et l'épitaxie par jets moléculaires, En ablation laser, les paramètres principaux qui influent sur l'orientation cristalline du film sont la température du substrat et la pression d'oxygène. Il en est de même pour les autres techniques de dépôts, car cette orientation est liée à la variation de l'anisotropie de la cinétique de croissance des faces 100 (ou 010) et 001, et des paramètres cristallins en fonction de ces deux paramètres. La réalisation de telles épitaxies in-situ garantit une interface abrupte et par là-même un bon transfert des paires d'électrons de Cooper à travers une jonction.

L'invention a été décrite, à titre d'exemple, sur une jonction Josephson possédant deux films 9 et 11 de part et d'autre de la barrière 10. Elle s'applique également à des structures de type supraconducteur - métal normal, ou supraconducteur - isolant - métal normal, mais une structure symétrique est préférable pour profiter tout au long de la chaîne du supra-courant.

L'invention s'applique à la réalisation de jonctions Josephson pour l'électronique rapide, surtout l'électronique numérique, ainsi qu'à la réalisation de matériels de mesure du champ magnétique, notamment ceux qui sont connus sous le nom de SQUID, c'est à dire Superconducting Quantum Interface Device, en configuration sandwich.

Elle est précisée par les revendications suivantes.

## Revendications

1. Structure de jonction Josephson, formée entre une barrière (10) non supraconductrice et au moins un film (9) en matériau supraconducteur à haute température de la famille (TR) Ba Cu O, dans laquelle TR est une terre rare, ledit film étant supporté par au moins une couche (8) d'accès électrique en matériau supraconducteur, de la même famille (TR) BaCuO que le film (9), le grand axe "c" de la maille cristalline du film (9) étant perpendiculaire au grand axe "c" de la maille cristalline de la couche d'accès (8), lesdits axes "c" étant perpendiculaires aux plans CuO de matériau supraconducteur et la couche d'accès (8) étant orientée de façon que le grand axe "c" de sa maille cristalline soit perpendiculaire au plan de la jonction.

2. Structure selon la revendication 1, caractérisée en ce qu'au moins un contact électrique (13) est pris sur au moins une couche d'accès (8) par l'intermédiaire d'un fragment de film (15) de même nature et même orientation cristalline que le film (9) supraconducteur qui forme la jonction avec la barrière (10).

3. Structure selon la revendication 1, caractérisée en ce que la barrière (10) est en matériau non-supraconducteur de type isolant, ou métal normalement conducteur, ou semiconducteur.

## Patentansprüche

1. Struktur eines Josephson-Übergangs zwischen einer nicht-supraleitenden Barriere (10) und mindestens einer Schicht (9) aus einem bei "hoher" Temperatur supraleitendem Material der Familie (TR)BaCuO, wobei TR eine seltene Erde ist und die Schicht auf mindestens einer elektrischen Zugangsschicht (8) aus supraleitendem Material derselben Familie (TR)BaCuO wie die Schicht (9) ruht, wobei die große Achse "c" des Kristallgitters der Schicht (9) senkrecht zur großen Achse "c" des Kristallgitters der Zugangsschicht (8) verläuft und die beiden Achsen "c" senkrecht zu den Kupferoxidebenen des supraleitenden Materials verlaufen und wobei die Zugangsschicht (8) so ausgerichtet ist, daß die große Achse "c" ihres Kristallgitters senkrecht zur Ebene des Übergangs verläuft.

2. Struktur nach Anspruch 1, dadurch gekennzeichnet, daß mindestens ein elektrischer Kontakt (13) auf mindestens einer Zugangsschicht (8) über ein Fragment einer Schicht (15) der gleichen Art und Kristallausrichtung wie die supraleitende Schicht (9) hergestellt ist, die den Übergang zur Barriere (10) bildet.

3. Struktur nach Anspruch 1, dadurch gekennzeichnet, daß die Barriere (10) aus einem nicht-supraleitenden Material vom Typ Isolator, normalleitendes Metall oder Halbleiter besteht.

## Claims

1. A Josephson junction structure formed between a nonsuperconducting barrier (10) and at least one film (9) made of material which is superconducting at high temperature, of the (RE)BaCuO group in which RE is a rare earth, the said film being supported by at least one electrical access layer (8) made of superconducting material of the same (RE)BaCuO group as the film (9), the long axis "c" of the unit crystal lattice of the film (9) being perpendicular to the long axis "c" of the unit crystal lattice of the access layer (8), the said axes "c" being perpendicular to the CuO planes of superconducting material and the access layer (8) being oriented so that the long axis "c" of its unit crystal lattice is perpendicular to the plane of the junction.

2. A structure according to Claim 1, characterized in that at least one electrical contact (13) is taken on at least one access layer (8) by means of a fragment of film (15) of the same kind and same crystal orientation as the superconducting film (9) which forms the junction with the barrier (10).

3. A structure according to Claim 1, characterized in that the barrier (10) is made of nonsuperconducting material of an insulating type, or normally conducting metal, or semiconducting material.
